# EUROPEAN PATENT APPLICATION

(11) **EP 4 632 820 A1**
(43) Date of publication of application: **15.10.2025**
(21) Application number: 24169678.0
(22) Date of filing: 11.04.2024
(51) Int. Cl.: H01L 29/10, H01L 29/40, H01L 29/66, H01L 29/78, H01L 29/417, H01L 29/04

(54) **SEMICONDUCTOR DEVICE AND METHOD OF MANUFACTURING SAME**

(71) Applicant: Infineon Technologies Austria AG, 9500 Villach (AT)
(72) Inventor: LEOMANT, Sylvain, 9210 Pörtschach am Wörther See (AT); BREYMESSER, Alexander, 9500 Villach (AT); RÖSCH, Maximilian, 9524 St. Magdalen (AT)
(74) Representative: Infineon Patent Department

(57) **Abstract**

A semiconductor device comprises a semiconductor body having a first major surface. The semiconductor body comprises a source region of a first conductivity type, a body region of a second conductivity type, and a drift region of the first conductivity type. A first trench extends from the first major surface of the semiconductor body into the semiconductor body along a first direction. A first gate electrode is located in the first trench. A second trench extends from the first major surface of the semiconductor body into the semiconductor body. A conductive material is located in the second trench. The conductive material is in electrical contact with the source region and the body region of the semiconductor body. A first sidewall of the second trench corresponds to a first lattice plane of the semiconductor body.

## Description

### BACKGROUND

Transistor devices used in power electronic applications are often fabricated with silicon (Si) semiconductor materials. Common transistor devices for power applications include Si CoolMOSO, Si Power MOSFETs and Si Insulated Gate Bipolar Transistors (IGBTs).

A transistor device for power applications may be based on the charge compensation principle and may include an active cell field including a plurality of trenches, each including a field electrode for charge compensation.

Further improvements would be desirable to further improve the performance of transistor devices, for example by finding ways to contact source and/or body regions of the transistor device which may lead to less processing variations.

### SUMMARY

According to an embodiment, a semiconductor device comprises a semiconductor body having a first major surface. The semiconductor body may comprise a source region of a first conductivity type, a body region of a second conductivity type, and a drift region of the first conductivity type. A first trench may extend from the first major surface of the semiconductor body into the semiconductor body along a first direction. A first gate electrode may be located in the first trench. A second trench may extend from the first major surface of the semiconductor body into the semiconductor body. A conductive material may be located in the second trench. The conductive material may be in electrical contact with the source region and the body region of the semiconductor body. A first sidewall of the second trench may correspond to a first lattice plane of the semiconductor body.

According to an embodiment, a method for fabricating a semiconductor device comprises forming at least one first trench in a semiconductor body made of a semiconductor material. The at least one first trench may extend from a first major surface of the semiconductor body into the semiconductor body along a first direction. The method may further comprise forming a second trench in the semiconductor body. The second trench may extend from the first major surface of the semiconductor body into the semiconductor body. Forming the second trench may comprise etching the semiconductor body with an etchant that comprises an etch rate which depends on lattice planes of the semiconductor material such that a first lattice plane of the semiconductor body forms a first sidewall of the second trench. The method may further comprise covering the second trench at least partially with a conductive material.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
FIG. 1 illustrates a partial cross-sectional view of a semiconductor device, according to embodiments of the present disclosure.
FIG. 2 illustrates a partial cross-sectional view of a semiconductor device, according to embodiments of the present disclosure.
FIG. 3A-3G illustrate several steps of an embodiment of producing the semiconductor device illustrated in FIGS. 1 and 2.
FIG. 4 illustrates a flow chart of an embodiment of producing the semiconductor device illustrated in FIGS. 1 and 2 and as shown in FIGs. 3A-3G.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor body. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n-" means a doping concentration which is lower than the doping concentration of an "n"-doping region while an "n+"-doping region has a higher doping concentration than an "n"-doping region. Doping regions of the same relative doping concentration do not necessarily have the same absolute doping concentration. For example, two different "n"-doping regions may have the same or different absolute doping concentrations.

According to embodiments, the semiconductor device is a transistor device (such as a power transistor device) and may be a MOSFET (Metal Oxide Semiconductor Field Effect Transistor) device, a superjunction transistor device or an insulated gate bipolar transistor (IGBT) device. The transistor device may be a vertical transistor device with a drift path that extends substantially perpendicularly to the major surfaces of the device.

The regions and terminals of the transistor device are referred to herein as source, drain and gate regions / terminals. As used herein, these terms also may encompass the functionally equivalent regions / terminals of other types of transistor devices, such as an insulated gate bipolar transistor (IGBT). For example, as used herein, the term "source" region / terminal may encompass not only a source region / terminal of a MOSFET device and of a superjunction device but also an emitter region / terminal of an insulator gate bipolar transistor (IGBT) device, the term "drain" region / terminal may encompass not only a drain of a MOSFET device or of a superjunction device but also a collector of an insulator gate bipolar transistor (IGBT) device and a collector of a BJT device, and the term "gate" region / terminal may encompass not only a gate of a MOSFET device or of a superjunction device but also a gate of an insulator gate bipolar transistor (IGBT) device.

Some embodiments are described next with reference to the Figures. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

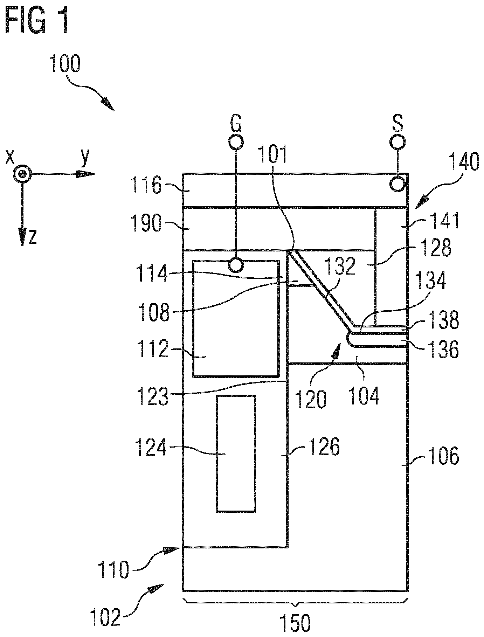

FIG. 1 illustrates a partial cross-sectional view of a semiconductor device, according to embodiments of the present disclosure.

Semiconductor device 100 may comprise a plurality of transistor cells, such as transistor cell 150 indicated in Fig. 1. Transistor cells (such as transistor cell 150) may be arranged in an active area of semiconductor device 100.

Transistor cell 150 comprises a semiconductor body 102 having a first major surface 101. Semiconductor body 102 may comprise (such as be made of) a semiconductor material (such as silicon, silicon carbide or gallium nitride). In some examples, the semiconductor material may be monocrystalline silicon. First major surface 101 may extend in (lateral) directions x and y and may be substantially perpendicular to a (vertical) direction z in which current may flow through transistor cell 150 of semiconductor device 100.

Semiconductor body 102 comprises a source region 108 of a first conductivity type (such as an n-type), a body region 104 of a second conductivity type that is opposite the first conductivity type (such as p-type in case the source region is n-type), and a drift region 106 of the first conductivity type (i.e., the same conductivity type as the source region 108). In addition, the semiconductor body 102 may further comprise a drain region (not shown in Fig. 1) of the first conductivity type. The source region 108 may be arranged at the first major surface 101 and may extend along the vertical direction z within the semiconductor body 102. The body region 104 may be arranged below the source region 108 along the vertical direction z. The drift region 106 may be arranged below the body region 104.

Transistor cell 150 may further comprise a first trench 110 formed in the semiconductor body 102. First trench 110 may extend from the first major surface 101 of semiconductor body 102 into the semiconductor body 102 along the vertical direction z. First trench 110 may comprise a gate electrode 112 and may optionally further comprise a field electrode 124 arranged below the gate electrode 112 (along the vertical direction z). Gate electrode 112 can selectively be charged via gate terminal G which can cause a current to flow through the semiconductor body 102 of semiconductor device 100 under appropriate biasing of the source region 108 and the drain region of the semiconductor device 100. Field electrode 124 can be charged (e.g., to source potential by connecting the field electrode 124 to the source terminal S) to perform charge compensation. Field electrode 124 (if present) may be electrically insulated from the semiconductor body 102 via a field dielectric 126 (such as at least one of an oxide, and a nitride). Gate electrode 112 may be electrically insulated via the semiconductor body 102 by a gate dielectric 114 (such as at least one of an oxide, and a nitride), which may be the same or different material as compared to the field dielectric 126.

First trench 110 may comprise a sidewall 123 that is adjacent to source region 108, body region 104, and drift region 106. Trench 110 may extend through the source region 108 and body region 104 into the drift region 106. In some examples, trench 110 is an elongated trench (also called stripe-shaped trench) when viewed from top. In other words, trench 110 may extend along a lateral direction (such as the x direction that is perpendicular to the cross-section viewed in Fig. 1).

Transistor cell 150 may further comprise a second trench 120 formed in the semiconductor body 102. Second trench 120 may extend from the first major surface 101 of semiconductor body 102 into the semiconductor body 102 along the vertical direction z. Second trench 120 may comprise a conductive material 138 such as a conductive layer arranged within the second trench and covering a bottom 134 of the second trench 120 and a sidewall 132 of the second trench 120 at least partially. In some embodiments, conductive material 138 may be a metal such as titanium and/or tungsten. In some examples, conductive material may comprise a conductive layer and one or more silicide layer. Conductive material 138 may be in electrical contact with source region 108 and body region 104. For example, conductive material 138 may be arranged in direct contact with source region 108 and body region 104, e.g., as at least one of a silicide layer, and a conductive layer disposed on sidewall 132 of second trench 120. In some embodiments, conductive material 138 may extend over the entire sidewall 132 and reach the first major surface 101 of semiconductor body 102. In other embodiments, conductive material may terminate below the first major surface 101 of semiconductor body 102 and above a junction formed by the source region 108 and body region 104 (such as still reaching upwards to contact the source region 108). Conductive material 138 may form a source contact with source region 108. For example, an electrical connection can be formed between source region 108 and source terminal S via conductive material 138 that extends to bottom 134 of second trench 120 where conductive material 138 may be in physical contact with conductive material 141.

According to embodiments, second trench 120 may comprise an insulating material 128 which may have a hole 140 (such as a recess) that is filled with a second conductive material 141. Second conductive material 141 may be in electrical contact with conductive material 138 at the bottom 134 of the second trench 120. In some examples, conductive material 138 may further comprise at least one of a silicide layer and a titanium nitride layer formed at an interface of the conductive material 138 with conductive material 141. In addition, second conductive material 141 may be in contact with conductive layer 116 (such as a metallization layer) which may be connected to a source terminal S. Apart from the electrical connection via the first and second conductive material 138 and 141, conductive layer 116 may be insulated from the semiconductor body 102 via insulating layer 190 which may be arranged between the first major surface 101 of the semiconductor body 102 and conductive layer 116. Hole 140 and second conductive material 141 may reach from conductive layer 116 through insulating layer 190 and through insulating material 128 to conductive material 138 within the second trench 120. Second trench 120 may also be referred to as "source/body contact trench". Second conductive material 141 can be the same or different material as the first conductive material 138. For example, the first conductive material 138, the second conductive material 141 and a material of conductive layer 116 could be any one of titanium, titanium nitride, tungsten, polysilicon, aluminum, aluminum copper alloy, and copper.

Second trench 120 may comprise a sidewall 132 that is adjacent to source region 108 and body region 104. Trench 120 may extend through the source region 108 into body region 104. In some examples, trench 120 is an elongated trench (also called stripe-shaped trench) when viewed from top. In other words, trench 110 may extend along the x-direction that is perpendicular to the cross-section viewed in Fig. 1.

According to embodiments of the present disclosure a slope of the sidewall 132 of the second trench 120 may substantially be constant along the majority of the sidewall 132 (such as along 80% of the sidewall or such as along 85% or 90% or 95% of the sidewall, or even 99% or more). This may be achieved by exposing a particular lattice plane of the semiconductor material of semiconductor body 102. For example, this can be achieved by using an etchant with an etch rate which depends on lattice planes of the semiconductor material such that a first lattice plane of the semiconductor body 102 forms sidewall 132 of the second trench 120 (as further detailed below). In other words, sidewall 132 of second trench 120 corresponds to a lattice plane of semiconductor body 102.

An angle α between the sidewall 132 of second trench 120 and the lateral direction y can be approximately 45° (± 1°) in case sidewall 132 corresponds to the (110) lattice plane of the semiconductor body 102 (e.g., in case semiconductor body 102 comprises monocrystalline silicon). In another embodiment, an angle α between the sidewall 132 of second trench 120 and the lateral direction y can be approximately 54.7° (± 1°) in case sidewall 132 corresponds to the (111) lattice plane of the semiconductor body 102 (e.g., in case semiconductor body 102 comprises monocrystalline silicon). The indicated deviations of 1° may arise due to a slight misalignment of the second trench 120 with respect to the respective lattice plane of the semiconductor body 102 and/or due to none-selectiveness of the etchant (as further discussed below). In case the sidewall 132 corresponds to the (110) lattice plane of semiconductor body 102, the vertical direction z may be parallel to the (100) lattice plane which may ensure a low dangling bond density at an interface between the gate dielectric 114 in first trench 110 and body region 104. However, the present disclosure is not limited to this particular case and is also contemplated to cover cases where sidewall 132 correspond to other lattice planes of semiconductor body 102 (such as the (111) lattice plane). The above-described angle α may be equal to the slope of sidewall 132 and may be substantially constant along the majority of the sidewall 132 (such as along 80% of the sidewall or such as along 90% or 95% of the sidewall, or even 99% or more).

When referring to particular lattice planes, the commonly known Miller indices notation is used.

At the first major surface 101 of semiconductor body 102, second trench 120 may extend to first trench 110 (such as may be located directly adjacent to first trench 110). In other words, an uppermost point of sidewall 123 of first trench 110 may be arranged directly adjacent to an uppermost point of sidewall 132 of second trench 120. In this case, at the first major surface 101, the source region 108 that is arranged between sidewall 123 of first trench 110 and sidewall 132 of second trench 120 may have a very small width such as 5 nm or less (such as 1 nm). In examples, the source region 108 may just have an edge (such as a single point) that is located at the first major surface 101. In other examples, the source region 108 may be entirely removed at the first major surface 101 and only be present slightly below the first major surface 101, such as in a depth (measured from the first major surface 101 in the vertical z-direction) of 0.5 nm, 1 nm, 5nm or 10 nm or even larger. In this case, sidewall 123 of first trench 110 and sidewall 132 of second trench 120 may be in direct contact with each other. In some examples, conductive material 138 arranged within the second trench 120 and on sidewall 132 may be in contact with gate dielectric 114 arranged within the first trench 110.

The sidewall 132 of second trench 120 corresponding to a lattice plane of the semiconductor body 102 may allow that a slope of the sidewall 132 of second trench 120 is substantially the same (such as constant) over a majority of the sidewall 132 of second trench 120. This may allow a similar or same distance between the first and second trenches 110 and 120 at a given vertical distance z from the first major surface 101, along the first and second trenches in lateral direction x. This may decrease fluctuations in performance values along the trenches (in lateral x-direction) as well as over multiple different transistor cells (in lateral y-direction).

Semiconductor body 102 may further comprise body contact region 136 located in body region 104 and adjacent at least to bottom 134 of second trench 120. Body contact region 136 may have the same conductivity type as the body region 104 but with a higher concentration of dopants as compared to the body region 104. Body contact region 136 may be in electrical contact with conductive material 138 (e.g., to form a body contact between the metallization layer 116 and body region 136.

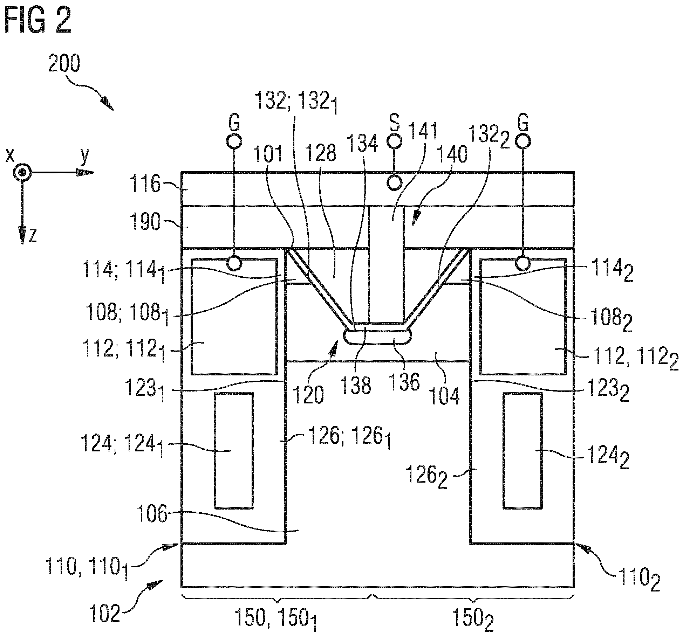

FIG. 2 illustrates a partial cross-sectional view of a semiconductor device 200, according to embodiments of the present disclosure. Semiconductor device 200 is similar to semiconductor device 100 as illustrated in FIG. 1 in that semiconductor device 200 comprises the same elements as semiconductor device 100 and additionally comprises a third trench 110₂ that is similar to the first trench 110, 110₁ and in that the second trench 120 comprises second sidewall 132₂. These additional elements may form a second transistor cell 150₂ in addition to the first transistor cell 150, 150₁ shown in FIG. 1. Second sidewall 132₂ may be symmetric to first sidewall 132₁. For example, second sidewall 132₂ has the same slope as first sidewall 132₁, where a sign of the slope is reversed (e.g., an absolute value of the slope of the first and second sidewalls 132₁, 132₂ may be the same). Same reference signs shall describe same elements which will not be described again, but instead reference is made to the above description with regard to elements that have already been described with regard to Fig. 1, which also applies to Fig. 2.

Second transistor cell 150₂ comprises a third trench 110₂ formed in the semiconductor body 102, which is similar to first trench 110 illustrated in Fig. 1 and indicated with 110, in Fig. 2. Third trench 110₂ may extend from the first major surface 101 of the semiconductor body 102 into the semiconductor body along the vertical direction z. Third trench 110₂ may comprise a gate electrode 112₂ and may optionally further comprise a field electrode 124₂ arranged below the gate electrode (along the vertical direction z). Field electrode 124₂ (if present) may be electrically insulated from the semiconductor body 102 via a field dielectric 126₂ (such as at least one of an oxide, and a nitride). Gate electrode 112₂ may be electrically insulated via the semiconductor body 102 by a gate dielectric 114₂ (such as at least one of an oxide, and a nitride), which may be the same or different material as compared to the field dielectric 126₂.

Third trench 110₂ may comprise a sidewall 123₂ that is adjacent to source region 108, body region 104, and drift region 106. Trench 110₂ may extend through the source region 108 and body region 104 into the drift region 106. In some examples, trench 110₂ is an elongated trench (also called stripe-shaped trench) when viewed from top. In other words, trench 110₂ may extend along the x-direction that is perpendicular to the cross-section viewed in Fig. 2.

Second trench 120 may comprise a second sidewall 132₂ in addition to the (first) sidewall 132, 132, discussed above. Similar to the first sidewall 132, 132₁, the second sidewall 132₂ may correspond to a lattice plane of semiconductor body 102. The lattice plane associated with the second sidewall 132₂ of the second trench 120 may be a lattice plane that is equivalent to the lattice plane associated with the first sidewall 132, 132, discussed above (e.g., if the first sidewall 132, 132, corresponds to the (110) lattice plane, the second sidewall 132₂ of the second trench 120 corresponds to a lattice plane that is equivalent to the (110) lattice plane, or if the first sidewall 132, 132, corresponds to the (111) lattice plane, the second sidewall 132₂ of the second trench 120 corresponds to a lattice plane that is equivalent to the (111) lattice plane). A lattice plane may be called equivalent to another lattice plane if both lattice planes are symmetric to each other with respect to a symmetry of the lattice (e.g., 90°-rotation around a symmetry axes)

Similar to what has been discussed above with regard to Fig. 1, this may allow having substantially the same slope at the second sidewall 132₂ along a majority of the second sidewall 132₂ (such as along 80% of the sidewall or such as along 90% or 95% of the sidewall, or even 99% or more). According to embodiments, the first sidewall 132, 132₁ and the second sidewall 132₂ of the second trench 120 may have a slope that have substantially a same absolute value (e.g., only the sign may be reversed). For example, this is the case, if the first sidewall 132, 132₁ and the second sidewall 132₂ of the second trench 120 correspond to an equivalent lattice plane.

As can be seen in FIG. 2 when viewed in a vertical cross section, second trench 120 of semiconductor device 200 may have a trapezoidal shape. In other words, bottom 134 of second trench 120 may be arranged substantially in parallel with the first major surface 101 of semiconductor body 102. In addition, a slope of first and second sidewalls 132₁ and 132₂ may substantially have a same absolute value. For example, in case the first sidewall 132₁ correspond to the (110) lattice plane and the second sidewall 132₂ corresponds to a lattice plane that is equivalent to the (110) lattice plane, an absolute value of an angle between the lateral direction y and the first and second sidewalls 132₁ and 132₂ may be substantially 45° (± 1°) over a majority of the first and second sidewalls 132₁ and 132₂. In another example, in case the first sidewall 132₁ correspond to the (111) lattice plane and the second sidewall 132₂ corresponds to a lattice plane that is equivalent to the (111) lattice plane, an absolute value of an angle between the lateral direction y and the first and second sidewalls 132₁ and 132₂ may be substantially 54.7° (±1°) over a majority of the first and second sidewalls 132₁ and 132₂.

Second trench 120 may separate source region 108 of semiconductor body 102 into a first source region 108₁ located adjacent the first trench 110, 110₁ and into a second trench region 108₂ located adjacent the third trench 110₂.

As discussed above with regard to Fig. 1, second trench 120 may comprise a conductive material 138 covering a bottom 134 of the second trench 120, first sidewall 132, 132₁ and second sidewall 132₂ of second trench 120 at least partially. Conductive material 138 may be in electrical contact with source region 108₁ and body region 104 of first transistor cell 150₁ and in electrical contact with source region 108₂ and body region 104 of second transistor cell 150₂. For example, conductive material 138 may be arranged in direct contact with first source region 108₁, second source region 108₂ and body region 104, e.g., as at least one of a silicide layer, and a conductive layer disposed on sidewall 132 of second trench 120. In some embodiments, conductive material 138 may extend over the entire first and second sidewalls 132₁, 132₂ and reach the first major surface 101 of semiconductor body 102 in proximity to the first trench 110₁ and in proximity to the third trench 110₂. In other embodiments, conductive material 138 may terminate below the first major surface 101 of semiconductor body 102 and above respective junctions formed by the first source region 108₁ with body region 104, and formed by the second source region 108₂ with body region 104. Conductive material 138 may form a source contact with first source region 108₁ and with the second source region 108₂. For example, an electrical connection can be formed between first and second source regions 108₁, 108₂ and source terminal S via conductive material 138 that extends to bottom 134 of second trench 120 where conductive material 138 may be in physical contact with conductive material 141. Conductive material 138 may terminate on the first sidewall 132₁ at substantially a same depth (e.g., distance from the first major surface 101 measured along the vertical direction z) as the second sidewall 132₂.

At the first major surface 101 of semiconductor body 102, second trench 120 may extend from the first trench 110, 110₁ to the third trench 110₂. In other words, a width w_{t,s} of the second trench 120 at the first major surface 101 may be equal to the mesa width wₘ (such as, the distance between the first trench 110, 110₁ and the second trench 110₂). In this case, the width w_{t,b} of bottom 134 of the second trench 120 is equal to wₘ - 2 · dₜ / tan α, where dₜ is a depth of the second trench 120 (such as from the first major surface 101 to the bottom 134 of second trench 120 or from an upper edge of second trench 120 to the bottom 134 of second trench 120) measured along the vertical direction z, where tan is the tangent function, and where α is the angle between the lateral direction y and the first and second sidewalls 132₁ and 132₂ of second trench 120. As discussed above, α may be 45° (± 1°) or 54.7° (± 1°).

The above discussed widths w_{t,s}, wₘ, w_{t,b} are measured along a lateral direction y which is orthogonal to the vertical direction z and orthogonal to the lateral direction x (into which the first, second, and third trenches 110, 110₁, 120, 110₂ may be elongated).

Mesa width wₘ may be chosen according to circumstances and may vary depending on voltage classes of semiconductor device 200. For example, for 40V voltage class a typical mesa width (such as a distance between first trench 110, 110₁ and third trench 110₂) may be around 500 nm (which would be equal to the width of the second trench 120 at the first major surface 101) and a typical depth for second trench 120 may be around 150 nm. In this case, a width w_{t,b} of the bottom of the second trench 120 would be around 200 nm (if α = 45°) and around 288 nm (if α = 54.7°) It is noted however, that the present disclosure is not limited to 40V voltage class, but different voltage classes are also possible and contemplated by the present disclosure. For example, the width of the second trench 120 at the first major surface 101 may be in a range between 150 nm and 1,000 nm, a width of the second trench 120 at the bottom 134 may be in a range between 20 nm and 500 nm, and a distance between the first major surface 101 and the bottom 134 (when measured along the vertical direction z) may be in a range between 100 nm and 400 nm. In one embodiment, a ratiobetween the width of the second trench 120 at the first major surface and the width of the second trench 120 at the bottom 134 is equal to or greater than 1.5 (w_{t,s} / w_{t,b} ≥ 1.5). In the same or in different embodiments, a ratio between the width of the bottom 134 of the second trench 120 and the depth of the second trench 120 is equal to or greater than 0.5 (w_{t,b} / dₜ ≥ 0.5).

As discussed above with regard to Fig. 1, first sidewall 132, 132₁ of second trench 120 corresponding to a lattice plane of the semiconductor body 102 may allow that a slope of the first sidewall 132, 132₁ of second trench 120 is substantially the same (such as constant) over a majority of the first sidewall 132, 132₁ of second trench 120. This may allow a similar or same distance between the first trench 110, 110₁ and second trench 120 at a given vertical distance z from the first major surface 101. In FIG. 2, there are two transistor cells illustrated, first transistor cell 150, 150₁ and second transistor cell 150₂.

Transistor cells 150₁ and 150₂ may be substantially symmetric with respect to each other. For example, a slope of the first and second sidewalls 132₁ and 132₂ of second trench may be substantially the same over a majority of the first and second sidewalls 132₁, 132₂. In embodiments, at a given depth d from the first major surface 101 along the vertical direction z, a distance between the first trench 110₁ and the second trench 120 (along the first sidewall 132₁) may be the same as a distance between the third trench 110₂ and the second trench 120 (along the second sidewall 132₂). This may allow the first and second transistors 150₁ and 150₂ to have similar performance values (i.e., less fluctuation in performance values among them). In addition or as an alternative, this may allow that contact hole 140 does not need to be perfectly aligned with first and third trenches 110₁ and 110₃. Conventionally contact hole 140 had to be aligned precisely to the middle between first and third trenches 110₁ and 110₃. Due to a symmetric layout (such as trapezoidal shape) of second trench 120 with first and second sidewalls 132₁ and 132₂ of second trench corresponding to a lattice plane of semiconductor body 102, contact hole 140 can be misaligned without affecting performance values of transistor cells 150₁ and 150₂.

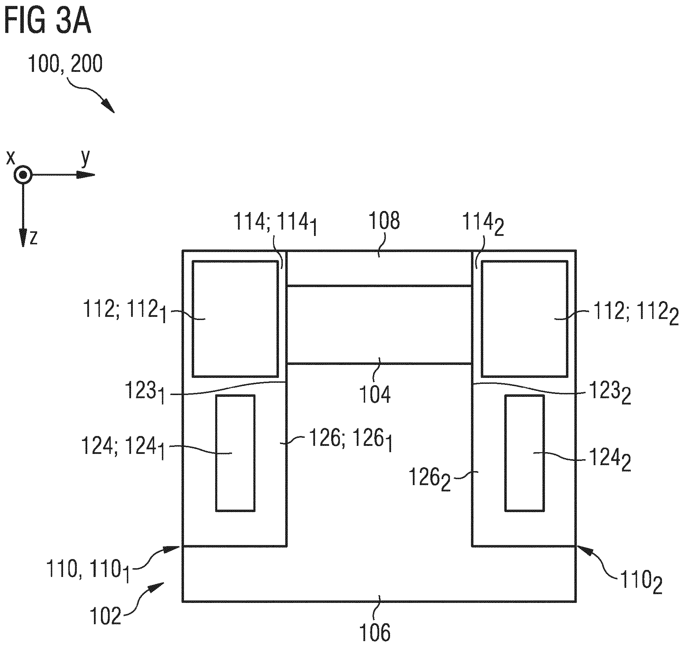

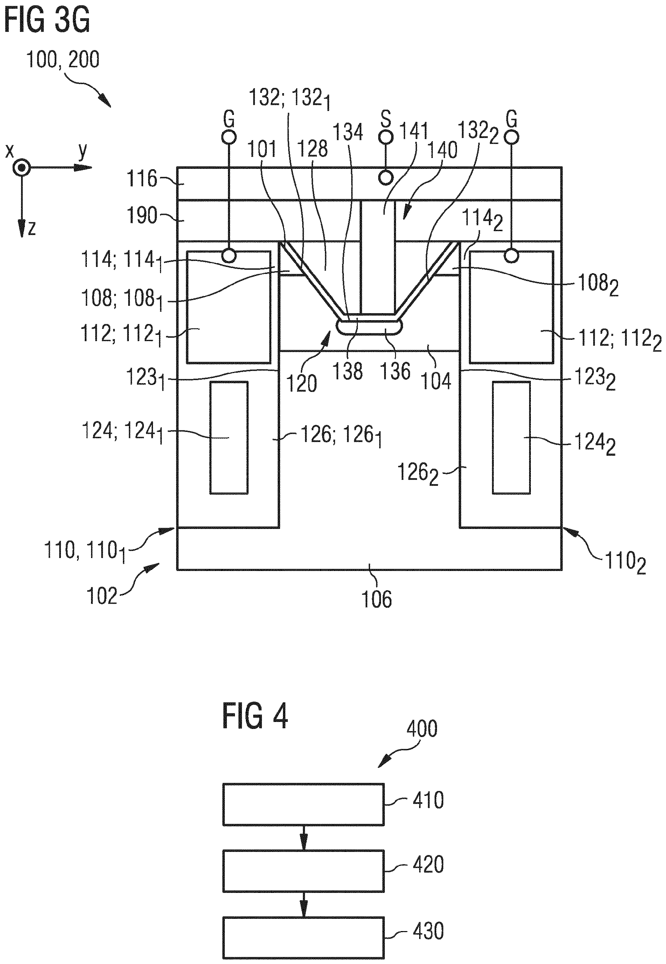

FIGS. 3A-3G and 4 illustrates an embodiment of producing the semiconductor device 100, 200 (such as the ones illustrated in FIGS. 1 and 2). Like reference signs in FIGS. 3A-3G that are already present in Figs. 1 and 2 shall refer to same elements and their description is not repeated here, but reference is made to the description of these elements made above.

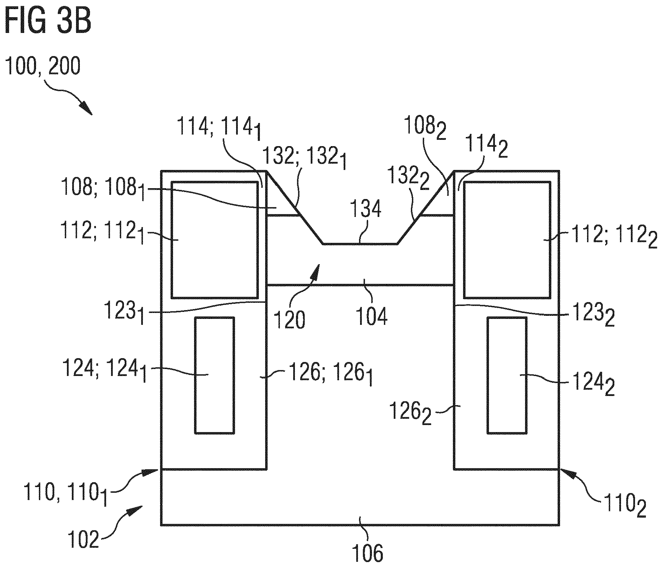

FIG. 3A illustrates a semiconductor device 100, 200 after forming 410 of first trench 110, 110₁ and third trench 110₂ in semiconductor body 102 and respective elements therein. First trench 110, 110₁ and third trench 110₂ extend from first major surface 101 of semiconductor body 102 into the semiconductor body 102 along a vertical direction z. Forming 410 the at least one first trench 110; 110₁ may comprises forming the at least one first trench 110; 110₁ along a second (lateral) direction x that is orthogonal to the first (vertical) direction z, e.g., in case an elongated trench 110 is formed. For example, the at least one trenches may be oriented along a (100) lattice plane direction of the semiconductor body 102. In this example, an intersection line of sidewall 123₁ of first trench 110₁ with the first major surface 101 of semiconductor body 102 and an intersection line of sidewall 123₂ of third trench 110₂ with the first major surface 101 of semiconductor body 102 may be oriented in (100)-lattice direction of the semiconductor body. FIG. 3B illustrates semiconductor device 100, 200 after forming 420 a second trench 120 in semiconductor body 102. The second trench 120 may extend from the first major surface 101 of the semiconductor body 102 into the semiconductor body 102. The second trench 120 may be formed by etching the semiconductor body 102 with an etchant that comprises an etch rate which depends on lattice planes of the semiconductor material such that a first lattice plane of the semiconductor body 102 forms a first sidewall 132₁ of the second trench 120. For example, the etchant is at least one of tetramethylammoniumhydroxid (TMAH), potassium hydroxide (KOH), and ethylenediamine pyrocatechol (EDP). The semiconductor material of the semiconductor body 102 may be monocrystalline silicon. The second trench 120 may be more shallow than the at least one first trench 110, 110₁ (when measured along the vertical direction z). In addition, forming the second trench 120 may comprise forming the second trench along the lateral x direction in parallel with the at least one first trench 110, in case elongated trenches are formed.

A gate electrode 112₁ and 112₂ in the first trench 110; 110₁ and third trench 110₂ may be covered by an oxide. The first and third trenches 110₁, 110₂ can be used as a hard mask when forming the second trench 120 in the semiconductor body 102 via etching. As discussed above, the etchant comprises an etch rate which depends on lattice planes of the semiconductor material. In other words, the etchant is an anisotropic etchant. In embodiments, an etch rate of the etchant may be substantially smaller with regard to a particular lattice plane of semiconductor body 102 as compared to other lattice planes (e.g., it may have a selectivity of 50 to 1, meaning that the other lattice planes are etched 50 times faster than the particular lattice plane).

For example, a (100) lattice plane and a (110) lattice plane are tilted 45° with respect to each other. The etchant may have a higher etch rate on the (110) lattice plane and a lower etch rate on the (100) lattice plane. In some examples the etch rate on the (110) lattice plane may be lowered by adding one or more additives (such as surface active agents) to the etchant.

Nevertheless, a residual etch rate on the (110) lattice plane may lead to etching away a fraction of the source region 108 such that a (remaining) upper portion of the source region may be located below the first major surface 101 of semiconductor body 102 (as discussed above). In one example, the etchant is TMAH and the additive may be octoxynol-9. Etching with an etchant that comprises an etch rate which depends on lattice planes of the semiconductor material may expose a particular lattice plane as a first sidewall 132, 132₁ and as a second sidewall 132₂ of second trench 120. Similarly, this may result in the first and the second sidewalls 132₁ and 132₂ having a same shape. For example, a slope of the first and second sidewalls 132₁ and 132₂ may be substantially the same over a majority of the first and second sidewalls 132₁ and 132₂ with only a sign of the slope being reversed. As a consequence, also a distance between the first trench 110₁ and the second trench 120 (along the first sidewall 132₁) may be the same as a distance between the third trench 110₂ and the second trench 120 (along the second sidewall 132₂) for a given vertical distance d from the first major surface 101. This may allow the first and second transistors 150₁ and 150₂ to have similar performance values (i.e., less fluctuation in performance values among them).

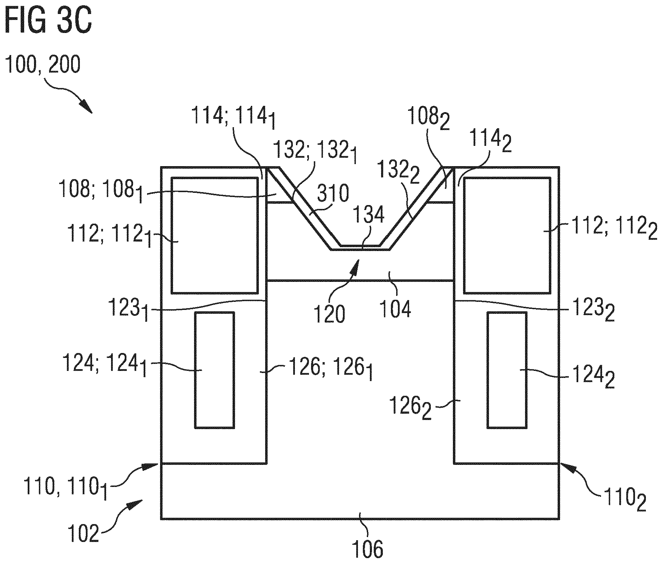

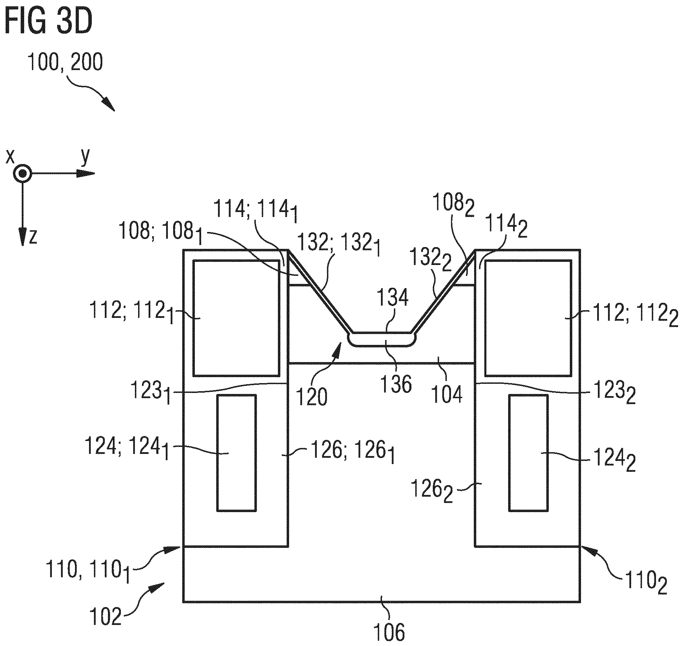

Fig. 3C illustrates a semiconductor device 100, 200 where a shielding layer 310 (such as an oxide or a nitride) has been formed on sidewalls 132₁, 132₂ and bottom 134 of second trench 120. For example, the shielding layer 310 may be grown or deposited on sidewalls 132₁, 132₂ and bottom 134 of second trench 120. In one example the shielding layer 310 may comprise silicon oxide. Shielding layer 310 may decrease an amount of implants that may enter into source region 108 and into body region 134 (next to sidewalls 132₁, 132₂ of second trench 120) in a subsequent step (and as further discussed below with regard to Fig. 3D). In some examples, shielding layer 310 may be thinned (such as via an anisotropic dry etch) at bottom 134 of second trench. This may allow having a thicker shielding layer 310 at sidewalls 132₁, 132₂ as compared to at bottom 134 of second trench 120, which may allow for more implants being able to enter semiconductor body 102 via bottom 134 as compared to via sidewalls 132₁, 132₂.

Fig. 3D illustrates a semiconductor device 100, 200 after an implantation step of dopants has been carried out on the device shown in Fig. 3C and shielding layer 310 has been removed. The implants close to the bottom 134 of second trench 120 may form a body contact region 136 that comprises a higher doping concentration as compared to the body region 104.

In some examples (e.g., in case the body region 104 is of the p-conductivity type), the implantation may be a boron implantation (e.g., using boron fluoride). As discussed above, an amount of implants entering semiconductor body 102 via sidewalls 132₁, 132₂ may be reduced as compared to an amount of implants entering semiconductor body 102 via bottom 134 of second trench (e.g., due to the shielding layer 310 being thinner at the bottom 134 of second trench 120 as compared to on the sidewalls 132₁, 132₂ during the implantation process).

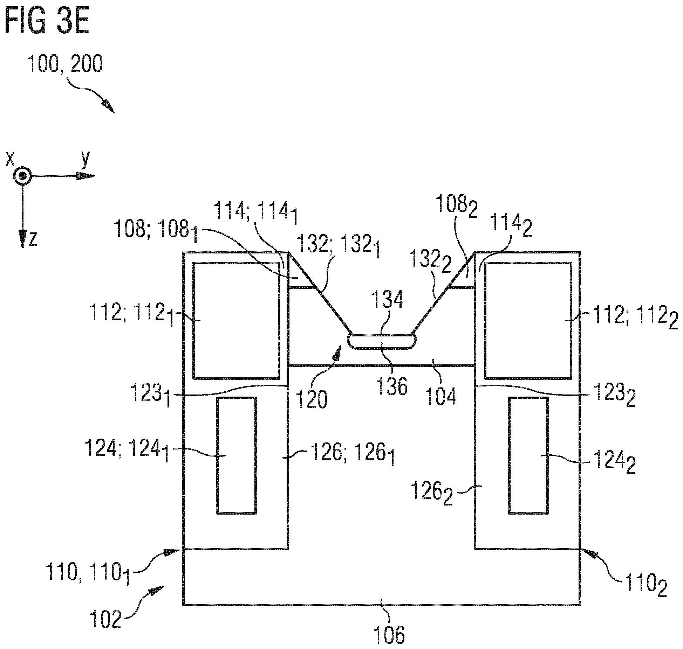

Fig. 3E shows an optional step of removing the implants from sidewalls 132₁, 132₂, e.g., using anisotropic etching (e.g., using the same or a different etchant that was used to form the second trench 120).

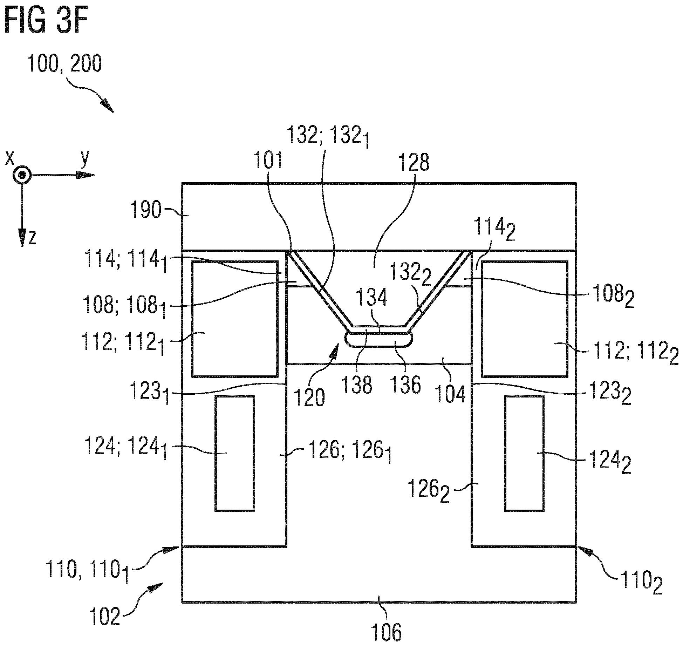

Fig. 3F illustrates a semiconductor device 100, 200 where sidewalls 132₁, 132₂ and bottom 134 of second trench 120 have been covered (at least partially with a conductive material 138). For example, conductive material 138 may be a metal such as titanium or tungsten. In addition, conductive material 138 may be silicided (such as comprising a silicide layer, e.g., comprising titanium silicide or tungsten silicide) for contact formation with the source region 108 and body region 104. In some cases, conductive material 138 may cover the first and second sidewalls 132₁, 132₂ and bottom 134 of second trench 120 completely. The conductive material 138 may be arranged directly on source region 108, 108₂ and directly on body region 104.

In addition, semiconductor device 100, 200 as illustrated in Fig. 3F comprises a first insulating material 128 which may fill the remainder of second trench 120 and a second insulating material 190 which may be deposited over the first major surface 101 of semiconductor body 102. Second insulating material 190 may cover the first trench 110, 110₁, second trench 120 and third trench 110₂. In some examples, first insulating material 128 may formed via high density plasma deposition. In different examples, the second insulating material 190 may be a boronphosphosilicate glass (BPSG).

Fig. 3G illustrates a semiconductor device 100, 200, where a contact hole 140 has been formed (e.g., via an etching process) in the first insulating material 128 and in the second insulating material 190. The contact hole 140 is filled with a second conductive material 141. In addition, a metallization layer 116 is formed over second insulating material 190. The metallization layer 116 can be formed at the same process step when the second conductive material 141 is filled into contact hole 140 or in a separate subsequent step. Conductive material 141 may extend from the metallization layer 116 to the conductive material 138 to form an electrical contact between the metallization layer 116 and the source region 108, 108₂ and the body region 104 (via conductive material 138). The contact hole 140 does not necessarily have to be located in a middle position between the first trench 110₁ and the third trench 110₂, which may decrease manufacturing complexity and/or allow the first and second transistors 150₁, 150₂ to have equal performance parameters (even though the contact hole 140 is not located in the middle position between the first trench 110₁ and the third trench 110₂.

FIG. 4 illustrates a flow chart of an embodiment of producing a semiconductor device (such as semiconductor device 100, 200).

The method comprises forming 410 at least one first trench 110; 110₁ in a semiconductor body 102 made of a semiconductor material (such as monocrystalline silicon). The at least one first trench 110; 110₁ may extends from a first major surface 101 of semiconductor body 102 into the semiconductor body 102 along a first direction z. Forming 410 the at least one first trench may further comprise 110; 110₁ forming the at least one first trench 110; 110₁ along a second direction x that is orthogonal to the first direction z. In some embodiments the second direction x is oriented based on a direction of a first lattice plane of semiconductor body 102 (e.g., orthogonal to the first lattice plane or with a particular other angle with respect to the first lattice plane).

Subsequently, a second trench 120 is formed 420 in the semiconductor body 102. The second trench 120 may extend from the first major surface 101 of semiconductor body 102 into the semiconductor body 102. According to embodiments the at least one first trench 110; 110₁ extends deeper into the semiconductor body 102 as compared to the second trench 120. Forming 420 the second trench 120 may comprise etching the semiconductor body with an etchant that comprises an etch rate which depends on lattice planes of the semiconductor material such that a first lattice plane of the semiconductor body 102 forms a first sidewall 132, 132₁ of the second trench 120, and optionally such that a second lattice plane of the semiconductor body 102 forms a second sidewall 132₂ of the second trench 120. In some embodiments, the at least one first trench 110; 110, comprises a plurality of first trenches 110₁, 110₂, and wherein the plurality of first trenches 110₁, 110₂ are used as a hard mask when forming 420 the second trench 120 in the semiconductor body 102 via etching. The etchant for etching the second trench 120 (such that the sidewalls 132₁, 132₂ correspond to lattice planes of the semiconductor body) may be at least one of tetramethylammoniumhydroxid, potassium hydroxide, and ethylenediamine pyrocatechol.

Subsequently, the second trench 120 is covered 430 at least partially with a conductive material 138. In some examples, the first and second sidewalls 132₁, 132₂ and bottom 134 of second trench 120 are fully covered with conductive material 138 (e.g., with a conductive layer).

Before covering 430 the second trench 120 at least partially with the conductive material 138, optionally the following steps can be performed. A shielding layer 310 can be deposited on bottom 138 and sidewalls 132₁, 132₂ of the second trench (120). Then, dopants can be implanted through shielding layer 310 to form a body contact region 136 in the semiconductor body 102 adjacent to the second trench 120. Next, shielding layer 310 can be removed from bottom 138 and sidewalls 132₁, 132₂ of the second trench 120. In some examples, before the dopants are implanted through the shielding layer 310, the shielding layer 310 may be thinned at the bottom 134 of the second trench 120.

After covering 430 the second trench 120 at least partially with the conductive material 138, optionally the following steps can be performed. The second trench 120 may be filled with a first insulating material 128. Next, a second insulating material 190 may be disposed over the at least one first trench 110₁, 110₂ and the second trench 120. Subsequently, a contact hole 140 may be formed in the first insulating material 128 and in the second insulating material 190. Next, contact hole 140 may be filled with a second conductive material 141 (which may be the same of different from the first conductive material).

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

It is to be understood that the features of the various embodiments described herein may be combined with each other, unless specifically noted otherwise.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

The following lists a set of examples that may be useful for understanding the present disclosure:
Example 1: A semiconductor device (100; 200), comprising:
   a semiconductor body (102) having a first major surface (101), wherein the semiconductor body (102) comprises a source region (108) of a first conductivity type, a body region (104) of a second conductivity type, and a drift region (106) of the first conductivity type;
   a first trench (110; 110₁) extending from the first major surface (101) of the semiconductor body (102) into the semiconductor body (102) along a first direction (z),
   a first gate electrode (112; 112₁) located in the first trench (110; 110₁);
   a second trench (120) extending from the first major surface (101) of the semiconductor body (102) into the semiconductor body (102); and
   a conductive material (138) located in the second trench (120), wherein the conductive material (138) is in electrical contact with the source region (108) and the body region (104) of the semiconductor body (102); and
   wherein a first sidewall (132; 132₁) of the second trench (120) corresponds to a first lattice plane of the semiconductor body (102).
Example 2: The semiconductor device (100; 200) of example 1,
   wherein a slope of the first sidewall (132; 132₁) is substantially the same along a majority of the first sidewall (132; 132₁).
Example 3: The semiconductor device (100; 200) of example 1 or 2, further comprising
   a third trench (110z) extending from the first major surface (101) of the semiconductor body (102) into the semiconductor body (102) along the first direction (z); and
   a second gate electrode (112; 112₂) located in the third trench;
   wherein a second sidewall (132₂) of the second trench (120) corresponds to a second lattice plane of the semiconductor body (102).
Example 4: The semiconductor device (100; 200) of example 3,
   wherein a slope of the second sidewall (132₂) is substantially the same along a majority of the second sidewall (132₂), and
   wherein the slope of the first sidewall (132; 132₁) and the slope of the second sidewall (132₂) have substantially the same absolute value.
Example 5: The semiconductor device of example 4,
   wherein the first lattice plane and the second lattice plane are equivalent lattice planes.
Example 6. The semiconductor device (100; 200) of any of the preceding examples,
   wherein the first trench (110; 110₁), and the second trench (120) are elongated in a second direction (x), the second direction (x) being orthogonal to the first direction (z).
Example 7. The semiconductor device (100; 200) of any of the preceding examples,
   wherein the second trench (120) comprises a bottom (134), and
   wherein the bottom (134) of the second trench (120) has a width measured along a third direction (y), the third direction (y) being orthogonal to the first direction (z).
Example 8. The semiconductor device (100; 200) of example 7, further comprising:
   a body contact region (136) located in the body region (104) and adjacent at least to the bottom (134) of the second trench (120), wherein the body contact region (136) is of the same conductivity type as the body region (104), wherein the body contact region (136) comprises a higher concentration of dopants as the body region (104); and
   wherein the conductive material (138) is in electrical contact with the body contact region (136).
Example 9: The semiconductor device (100; 200) of any of the preceding examples, further comprising:
   a first field electrode (124; 124₁) located in the first trench (110; 110₁); and
   at least one dielectric layer (114, 126; 114₁, 126₁) located in the first trench (110; 110₁) and covering a bottom and sidewalls of the first trench (110; 110₁).
Example 10: The semiconductor device (100; 200) of any of the preceding examples, further comprising:
   an insulating layer (190) covering at least the first trench (110; 110₁) and the second trench (120); and
   a conductive layer (116) over the insulating layer (190).
Example 11: The semiconductor device (100; 200) of example 10, further comprising:
   a contact hole (140) formed in the insulating layer (190) and in contact with the conductive material (138) located in the second trench (120),
   wherein the contact hole (140) is filled with a second conductive material (141).
Example 12: The semiconductor device (100; 200) of any of examples 3 to 11,
   wherein, at the first major surface (101), the second trench (120) extends from a first sidewall (123₁) of the first trench (110; 110₁) to a second sidewall (123₂) of the third trench (110₂).
Example 13: The semiconductor device of example 12,
   wherein, at the first major surface (101), the second trench has a first width measured along a third direction (y), the third direction (y) being orthogonal to the first direction (z)
   wherein the second trench (120) comprises a bottom (134), wherein the bottom (134) of the second trench (120) has a second width measured along the third direction (y),
   wherein the first width is at least 1.5 times greater than the second width.
Example 14: The semiconductor device (100; 200) of any of examples 3 to 12,
   wherein a distance between the first trench (110; 110₁) and the second trench (120) is substantially equal to a distance between the second trench (120) and the third trench (110₂) when measured along the third direction (y) at a same distance from the first major surface (101) along the first direction (z).
Example 15: The semiconductor device (100; 200) of any of the preceding examples,
   wherein the semiconductor body (102) is formed of monocrystalline silicon, and
   wherein the first lattice plane is the (110) lattice plane or the (111) lattice plane.
Example 16: The semiconductor device (100; 200) of any of examples 4 to 15,
   wherein the absolute value of the slope of the first sidewall (132; 132₁) and the absolute value of the slope of the second sidewall (132₂) is larger or equal to 44° and smaller or equal to 46°.
Example 17: The semiconductor device (100; 200) of any of examples 4 to 15,
   wherein the absolute value of the slope of the first sidewall (132; 132₁) and the absolute value of the slope of the second sidewall (132₂) is larger or equal to 53.7° and smaller or equal to 55.7°.
Example 18: A method (400) for fabricating a semiconductor device (100; 200), the method comprising:
   forming (410) at least one first trench (110; 110₁) in a semiconductor body (102) made of a semiconductor material,
   wherein the at least one first trench (110; 110₁) extends from a first major surface (101) of the semiconductor body (102) into the semiconductor body (102) along a first direction (z);
   forming (420) a second trench (120) in the semiconductor body,
   wherein the second trench (120) extends from the first major surface (101) of the semiconductor body (102) into the semiconductor body (102),
   wherein forming (420) the second trench (120) comprises etching the semiconductor body with an etchant that comprises an etch rate which depends on lattice planes of the semiconductor material such that a first lattice plane of the semiconductor body (102) forms a first sidewall of the second trench (120); and
   covering (430) the second trench (120) at least partially with a conductive material (138).
Example 19: The method (400) of example 18,
   wherein the at least one first trench (110; 110₁) extends deeper into the semiconductor body (102) as compared to the second trench (120).
Example 20: The method (400) of example 18 or 19,
   wherein forming (410) the at least one first trench comprises (110; 110₁) forming the at least one first trench (110; 110₁) along a second direction (x) that is orthogonal to the first direction (z),
   wherein the second direction (x) is parallel to the (100) lattice plane.
Example 21: The method (400) of any of examples 18 to 20,
   wherein the at least one first trench (110; 110₁) comprises a plurality of first trenches, and wherein the plurality of first trenches are used as a hard mask when forming the second trench (120) in the semiconductor body via etching.
Example 22: The method (400) of any of examples 18 to 21, the method further comprising:
   before covering (430) the second trench (120) at least partially with the conductive material:
   forming a shielding layer (310) on bottom and sidewalls of the second trench (120);
   implanting dopants through the shielding layer to form a body contact region (136) in the semiconductor body (102) adjacent to the second trench (120); and
   removing the shielding layer from the bottom and sidewalls of the second trench (120).
Example 23: The method (400) of example 22, the method further comprising:
   before implanting the dopants through the shielding layer (310), thinning the shielding layer (310) at the bottom (134) of the second trench (120).
Example 24: The method (400) of any of examples 18 to 23, the method further comprising:
   after covering (430) the second trench (120) at least partially with the conductive material (138):
   filing the second trench with a first insulating material (128);
   depositing a second insulating material (190) over the at least one first trench and the second trench;
   forming a contact hole (140) in the first insulating material and in the second insulating material; and
   filing the contact hole with a second conductive material (141).
Example 25: The method (400) of any of examples 18 to 24,
   wherein the etchant is at least one of tetramethylammoniumhydroxid, TMAH, potassium hydroxide, KOH, and ethylenediamine pyrocatechol, EDP,
   wherein the semiconductor material is monocrystalline silicon, and
   wherein the first lattice plane is the (110) lattice plane or the (111) plane.

## Claims

1. A semiconductor device (100; 200), comprising:
a semiconductor body (102) having a first major surface (101), wherein the semiconductor body (102) comprises a source region (108) of a first conductivity type, a body region (104) of a second conductivity type, and a drift region (106) of the first conductivity type;
a first trench (110; 110₁) extending from the first major surface (101) of the semiconductor body (102) into the semiconductor body (102) along a first direction (z),
a first gate electrode (112; 112₁) located in the first trench (110; 110₁);
a second trench (120) extending from the first major surface (101) of the semiconductor body (102) into the semiconductor body (102); and
a conductive material (138) located in the second trench (120), wherein the conductive material (138) is in electrical contact with the source region (108) and the body region (104) of the semiconductor body (102); and
wherein a first sidewall (132; 132₁) of the second trench (120) corresponds to a first lattice plane of the semiconductor body (102).

2. The semiconductor device (100; 200) of claim 1,
wherein a slope of the first sidewall (132; 132₁) is substantially the same along a majority of the first sidewall (132; 132₁).

3. The semiconductor device (100; 200) of claim 1 or 2, further comprising
a third trench (110z) extending from the first major surface (101) of the semiconductor body (102) into the semiconductor body (102) along the first direction (z); and
a second gate electrode (112; 112₂) located in the third trench;
wherein a second sidewall (132₂) of the second trench (120) corresponds to a second lattice plane of the semiconductor body (102).

4. The semiconductor device (100; 200) of claim 3,
wherein a slope of the second sidewall (132₂) is substantially the same along a majority of the second sidewall (132₂), and
wherein the slope of the first sidewall (132; 132₁) and the slope of the second sidewall (132₂) have substantially the same absolute value.

5. The semiconductor device of claim 4,
wherein the first lattice plane and the second lattice plane are equivalent lattice planes.

6. The semiconductor device (100; 200) of any of the preceding claims,
wherein the first trench (110; 110₁), and the second trench (120) are elongated in a second direction (x), the second direction (x) being orthogonal to the first direction (z).

7. The semiconductor device (100; 200) of any of the preceding claims,
wherein the second trench (120) comprises a bottom (134), and
wherein the bottom (134) of the second trench (120) has a width measured along a third direction (y), the third direction (y) being orthogonal to the first direction (z).

8. The semiconductor device (100; 200) of claim 7, further comprising:
a body contact region (136) located in the body region (104) and adjacent at least to the bottom (134) of the second trench (120), wherein the body contact region (136) is of the same conductivity type as the body region (104), wherein the body contact region (136) comprises a higher concentration of dopants as the body region (104); and
wherein the conductive material (138) is in electrical contact with the body contact region (136).

9. The semiconductor device (100; 200) of any of the preceding claims, further comprising:
a first field electrode (124; 124₁) located in the first trench (110; 110₁); and
at least one dielectric layer (114, 126; 114₁, 126₁) located in the first trench (110; 110₁) and covering a bottom and sidewalls of the first trench (110; 110₁).

10. The semiconductor device (100; 200) of any of the preceding claims, further comprising:
an insulating layer (190) covering at least the first trench (110; 110₁) and the second trench (120), and
a conductive layer (116) over the insulating layer (190); and/or
a contact hole (140) formed in the insulating layer (190) and in contact with the conductive material (138) located in the second trench (120),
wherein the contact hole (140) is filled with a second conductive material (141).

11. The semiconductor device (100; 200) of any of claims 3 to 10,
wherein, at the first major surface (101), the second trench (120) extends from a first sidewall (123₁) of the first trench (110; 110₁) to a second sidewall (123₂) of the third trench (110₂).

12. The semiconductor device of claim 11,
wherein, at the first major surface (101), the second trench has a first width measured along a third direction (y), the third direction (y) being orthogonal to the first direction (z)
wherein the second trench (120) comprises a bottom (134), wherein the bottom (134) of the second trench (120) has a second width measured along the third direction (y),
wherein the first width is at least 1.5 times greater than the second width.

13. The semiconductor device (100; 200) of any of claims 3 to 11,
wherein a distance between the first trench (110; 110₁) and the second trench (120) is substantially equal to a distance between the second trench (120) and the third trench (110₂) when measured along the third direction (y) at a same distance from the first major surface (101) along the first direction (z).

14. The semiconductor device (100; 200) of any of the preceding claims,
wherein the semiconductor body (102) is formed of monocrystalline silicon, and
wherein the first lattice plane is the (110) lattice plane or the (111) lattice plane.

15. The semiconductor device (100; 200) of any of claims 4 to 14,
wherein the absolute value of the slope of the first sidewall (132; 132₁) and the absolute value of the slope of the second sidewall (132₂) is larger or equal to 44° and smaller or equal to 46°; or
wherein the absolute value of the slope of the first sidewall (132; 132₁) and the absolute value of the slope of the second sidewall (132₂) is larger or equal to 53.7° and smaller or equal to 55.7°.

16. A method (400) for fabricating a semiconductor device (100; 200), the method comprising:
forming (410) at least one first trench (110; 110₁) in a semiconductor body (102) made of a semiconductor material,
wherein the at least one first trench (110; 110₁) extends from a first major surface (101) of the semiconductor body (102) into the semiconductor body (102) along a first direction (z);
forming (420) a second trench (120) in the semiconductor body,
wherein the second trench (120) extends from the first major surface (101) of the semiconductor body (102) into the semiconductor body (102),
wherein forming (420) the second trench (120) comprises etching the semiconductor body with an etchant that comprises an etch rate which depends on lattice planes of the semiconductor material such that a first lattice plane of the semiconductor body (102) forms a first sidewall of the second trench (120); and
covering (430) the second trench (120) at least partially with a conductive material (138).

17. The method (400) of claim 16,
wherein the etchant is at least one of tetramethylammoniumhydroxid, TMAH, potassium hydroxide, KOH, and ethylenediamine pyrocatechol, EDP,
wherein the semiconductor material is monocrystalline silicon, and
wherein the first lattice plane is the (110) lattice plane or the (111) plane.

## Amended claims

### Amended claims in accordance with Rule 137(2) EPC.

1. A semiconductor device (100; 200), comprising:
a semiconductor body (102) having a first major surface (101), wherein the semiconductor body (102) comprises a source region (108) of a first conductivity type, a body region (104) of a second conductivity type, and a drift region (106) of the first conductivity type;
a first trench (110; 110₁) extending from the first major surface (101) of the semiconductor body (102) into the semiconductor body (102) along a first direction (z),
a first gate electrode (112; 112₁) located in the first trench (110; 110₁);
a second trench (120) extending from the first major surface (101) of the semiconductor body (102) into the semiconductor body (102);
a third trench (110₂) extending from the first major surface (101) of the semiconductor body (102) into the semiconductor body (102) along the first direction (z); and
a second gate electrode (112; 112₂) located in the third trench; and
a conductive material (138) located in the second trench (120), wherein the conductive material (138) is in electrical contact with the source region (108) and the body region (104) of the semiconductor body (102); and
wherein a first sidewall (132; 132₁) of the second trench (120) corresponds to a first lattice plane of the semiconductor body (102),
wherein a second sidewall (132₂) of the second trench (120) corresponds to a second lattice plane of the semiconductor body (102), and
wherein, at the first major surface (101), the second trench (120) extends from a first sidewall (123₁) of the first trench (110; 110₁) to a second sidewall (123₂) of the third trench (110₂).

2. The semiconductor device (100; 200) of claim 1,
wherein a slope of the first sidewall (132; 132₁) is substantially the same along a majority of the first sidewall (132; 132₁).

3. The semiconductor device (100; 200) of claim 1,
wherein a slope of the second sidewall (132₂) is substantially the same along a majority of the second sidewall (132₂), and
wherein the slope of the first sidewall (132; 132₁) and the slope of the second sidewall (132₂) have substantially the same absolute value.

4. The semiconductor device (100; 200) of any of the preceding claims,
wherein the first trench (110; 110₁), and the second trench (120) are elongated in a second direction (x), the second direction (x) being orthogonal to the first direction (z).

5. The semiconductor device (100; 200) of any of the preceding claims,
wherein the second trench (120) comprises a bottom (134), and
wherein the bottom (134) of the second trench (120) has a width measured along a third direction (y), the third direction (y) being orthogonal to the first direction (z).

6. The semiconductor device (100; 200) of claim 6, further comprising:
a body contact region (136) located in the body region (104) and adjacent at least to the bottom (134) of the second trench (120), wherein the body contact region (136) is of the same conductivity type as the body region (104), wherein the body contact region (136) comprises a higher concentration of dopants as the body region (104); and
wherein the conductive material (138) is in electrical contact with the body contact region (136).

7. The semiconductor device (100; 200) of any of the preceding claims, further comprising:
a first field electrode (124; 124₁) located in the first trench (110; 110₁); and
at least one dielectric layer (114, 126; 114₁, 126₁) located in the first trench (110; 110₁) and covering a bottom and sidewalls of the first trench (110; 110₁).

8. The semiconductor device (100; 200) of any of the preceding claims, further comprising:
an insulating layer (190) covering at least the first trench (110; 110₁) and the second trench (120),
a conductive layer (116) over the insulating layer (190), and
a contact hole (140) formed in the insulating layer (190) and in contact with the conductive material (138) located in the second trench (120),
wherein the contact hole (140) is filled with a second conductive material (141).

9. The semiconductor device of claim 1,
wherein, at the first major surface (101), the second trench has a first width measured along a third direction (y), the third direction (y) being orthogonal to the first direction (z)
wherein the second trench (120) comprises a bottom (134), wherein the bottom (134) of the second trench (120) has a second width measured along the third direction (y),
wherein the first width is at least 1.5 times greater than the second width.

10. The semiconductor device (100; 200) of any of the preceding claims,
wherein a distance between the first trench (110; 110₁) and the second trench (120) is substantially equal to a distance between the second trench (120) and the third trench (110₂) when measured along the third direction (y) at a same distance from the first major surface (101) along the first direction (z).

11. The semiconductor device (100; 200) of any of the preceding claims,
wherein the semiconductor body (102) is formed of monocrystalline silicon, and
wherein the first lattice plane is the (110) lattice plane or the (111) lattice plane.

12. A method (400) for fabricating a semiconductor device (100; 200), the method comprising:
forming (410) at least a first trench (110; 110₁) and a third trench (110₂) in a semiconductor body (102) made of a semiconductor material,
wherein the first trench (110; 110₁) and the third trench (110₂) extend from a first major surface (101) of the semiconductor body (102) into the semiconductor body (102) along a first direction (z);
forming (420) a second trench (120) in the semiconductor body,
wherein the second trench (120) extends from the first major surface (101) of the semiconductor body (102) into the semiconductor body (102),
wherein, at the first major surface (101), the second trench (120) extends from a first sidewall (123₁) of the first trench (110; 110₁) to a second sidewall (123₂) of the third trench (110₂),
wherein forming (420) the second trench (120) comprises etching the semiconductor body with an etchant that comprises an etch rate which depends on lattice planes of the semiconductor material such that a first lattice plane of the semiconductor body (102) forms a first sidewall (132; 132₁) of the second trench (120) and a second lattice plane of the semiconductor body (102) forms a second sidewall (132₂) of the second trench (120); and
covering (430) the second trench (120) at least partially with a conductive material (138).

13. The method (400) of claim 12, the method further comprising:
after covering (430) the second trench (120) at least partially with the conductive material (138):
filing the second trench with a first insulating material (128);
depositing a second insulating material (190) over the at least one first trench and the second trench;
forming a contact hole (140) in the first insulating material and in the second insulating material; and
filing the contact hole with a second conductive material (141).

14. The method (400) of claim 12 or 13,
the first trench and the third trench are used as a hard mask when forming the second trench (120) in the semiconductor body via etching.

15. The method (400) of any of claims 12 to 14,
wherein the etchant is at least one of tetramethylammoniumhydroxid, TMAH, potassium hydroxide, KOH, and ethylenediamine pyrocatechol, EDP,
wherein the semiconductor material is monocrystalline silicon, and
wherein the first lattice plane is the (110) lattice plane or the (111) plane.
